(19) **Europäisches Patentamt**
**European Patent Office**
**Office européen des brevets**

(11) **EP 0 759 657 A1**

(12) **EUROPÄISCHE PATENTANMELDUNG**

(43) Veröffentlichungstag:
26.02.1997 Patentblatt 1997/09

(51) Int. Cl.$^6$: **H03J 3/18**, H03B 5/12

(21) Anmeldenummer: 96112500.2

(22) Anmeldetag: 02.08.1996

(84) Benannte Vertragsstaaten:
DE ES FI GB SE

(30) Priorität: 19.08.1995 DE 19530544

(71) Anmelder: TEMIC TELEFUNKEN microelectronic GmbH
74072 Heilbronn (DE)

(72) Erfinder:
• Forstner, Hans-Peter
85643 Steinhöring (DE)

• Mann, Ulrich
96352 Wilhelmstahl (DE)
• Stump, Simon
85098 Grossmehring (DE)

(74) Vertreter: Maute, Hans-Jürgen, Dipl.-Ing.
TEMIC TELEFUNKEN microelectronic GmbH
Postfach 35 35
74025 Heilbronn (DE)

(54) **Verfahren zur Resonanzkreisabstimmung durch Veränderung der Speisespannung einer Kapazitätsdiode**

(57) Verfahren zur Resonanzkreisabstimmung eines Schwingkreises, bestehend aus wenigstens einer Spule, einem Kondensator und einer Kapazitätsdiode mit einem komplexen Widerstand, durch Veränderung einer Speisespannung über der Kapazitätsdiode, indem die Speisespannung Werte sowohl im Sperrbereich ($U_D$ < 0 V) als auch im Durchlaßbereich ($U_D$ > 0 V) der Kapazitätsdiode annimmt.

FIG.1

## Beschreibung

Die Erfindung betrifft eine Resonanzkreisabstimmung durch Veränderung der Speisespannung einer Kapazitätsdiode gemäß dem Oberbegriff des Patentanspruchs 1 sowie dessen Verwendung.

Die kapazitive Wirkung von Dioden, bedingt durch die Ladungsträgerübersättigung im Durchlaßbereich (Durchlaßkapazität) und die Ladungsträgerausräumung im Sperrbereich (Sperrschichtkapazität), ist seit langem bekannt und wird technisch bei Kapazitätsdioden genutzt.

Die Veränderung der Speisespannung der Kapazitätsdiode in Sperrichtung stellt dabei insbesondere für mikroelektronische Schaltungen die wohl bekannteste Abstimmungsmethode für Schwingkreise dar.

Es wird die Abhängigkeit der Sperrschichtkapazität von der Speisespannung ausgenutzt und so die Gesamtkapazität im Schwingkreis sowie damit dessen Resonanzfrequenz gesteuert und abgestimmt. Dies findet in allen elektronischen Schwingkreisen mit LC-Wirkung auf der Grundlage von Reihen- oder Parallelschwingkreisen, eingesetzt in Empfängern, Filtern u. ä., Anwendung.

Es ist bekannt, daß hierzu die Kapazitätsdiode in Sperrichtung betrieben werden muß. Die Grenzen der Veränderbarkeit der Resonanzfrequenz, also der Durchstimmbereich des Schwingkreises, sind dabei durch die maximal zulässige Sperrspeisespannung sowie die Minimalvorspannung in Sperrichtung begrenzt.

Aufgabe der Erfindung ist es, ein Verfahren zur Resonanzkreisabstimmung mit einem vergrößerten Durchstimmbereich zu zeigen.

Die Aufgabe ist durch die kennzeichnenden Merkmale des Patentanspruchs 1 gelöst, indem im Gegensatz zur allgemeinen Lehrmeinung die Kapazitätsdiode auch in den Durchlaßbereich gesteuert wird.

Grundgedanke ist dabei, daß der imaginärteil der impedanz der Kapazitätsdiode in guter Näherung dargestellt werden kann als

$$IM\{Z\} = j\left[2\pi fL - \frac{1}{2\pi fC(u_D)}\right],$$

wobei die Variablen Z den komplexen Widerstand; L die parasitäre Induktivität und C ($U_D$) die von der Spannung $U_D$ abhängige Kapazität der Kapazitätsdiode D und f die Frequenz des Signals symbolisieren. Während in Sperrichtung die Kapazität der Diode immer kleiner wird und somit aufgrund der reziproken Wirkung der komplexe Widerstand Z immer stärker kapazitiv imaginär wird, so wird mit zunehmender Spannung in Durchlaßrichtung die Kapazität C sehr groß und ihre Wirkung auf den komplexen Widerstand Z derart klein, daß die Induktivität L, entsprechend durch parasitäre Eigenschaften, insbesondere die Anschlußinduktivität, den komplexen Widerstand Z immer mehr beeinflußt und schließlich Z sogar induktiv imaginär werden kann.

Trotz der Tatsache, daß bereits im Jahre 1975 [vgl. „Kapazitätsdioden, Schalterdioden, PIN-Dioden: Grundlagen und Anwendungen", ITT Intermetall GmbH Freiburg; Ausgabe 1975/8, S.15] eindeutig die kapazitive und induktive Wirkung von Dioden, insbesondere Kapazitätsdioden bekannt war, ist es auch dem Fachmann bisher nicht gelungen, unter Ausnutzung dieser Erkenntnis, auf derart einfache Weise ein komplexes Widerstandselement mit kapazitiv imaginärer und induktiv imaginärer Wirkung zu realisieren. Grund dafür dürfte wohl das Vorurteil des Fachmannes sein, daß Kapazitätsdioden sinnvoll nur in Sperrichtung für Schwingkreise einsetzbar sind, während deren Wirkung im Durchlaßbereich, nur der wissenschaftlichen Vollständigkeit wegen erwähnt, normalen Dioden gleichgesetzt und nie in Verbindung mit ihrer Verwendung in Schwingkreisen gesehen wurde.

Der Vorteil der Erfindung beruht einerseits auf dem deutlich vergrößerten Durchstimmbereich für Schwingkreise und andererseits auf der derart einfachen Realisierbarkeit. Letzteres ermöglicht den Einsatz in nahezu allen elektronischen Schaltungen mit Schwingkreiswirkung, ob in Reihen- oder Parallelschwingkreisen, Doppel-T-Brückenkreisen sowie in Filterschaltungen, Tunern u. ä., wo diese als Grundelemente zum Einsatz kommen.

In nahezu allen Schaltungen läßt sich auf einfache Weise die zur Ansteuerung notwendige, nun zweipolige Speisespannung für die Kapazitätsdiode gewinnen.

Der Patentanspruch 5 zeigt eine bevorzugte Verwendung der erfindungsgemäßen Resonanzkreisabstimmung in abstimmbaren Empfängern (Tunern), wodurch der Abstimmbereich der empfangbaren Frequenzen deutlich erweitert wird. Dies erweist sich insbesondere dadurch als äußerst vorteilhaft, da mit ständig zunehmender Verwendung funkgebundener Kommunikation, Bild- und Datenübertragung neue Frequenzbänder erschlossen werden müssen und eine derart einfache Lösung ein wettbewerbsentscheidendes Kostensenkungspotential eröffnet, da es diese neuen Frequenzbänder ohne zusätzliche, höchstentwickelte und damit teure Bauelemente, insbesondere Kapazitätsdioden, erschließen kann.

Die Erfindung soll nachfolgend anhand von Ausführungsbeispielen bezugnehmend auf die Figuren erläutert werden. Es zeigen:

Figur 1     eine Kapazitätsdiode D als Ausführungsbeispiel in einer Reihenschwingkreisschaltung mit einem Kondensator $C_o$ und einer Induktivität $L_o$ sowie das Kleinsignalersatzschaltbild der Kapazitätsdiode D nach dem Stand der Technik,

Figur 2     Funktionsverlauf der resultierenden Gesamtkapazität C gemäß der Schaltung in Figur 1,

Figur 3     Funktionsverlauf des komplexen Widerstands Z bzgl. der Spannung $U_D$ im Durchlaß- und Sperrbereich,

Figur 4    Durchstimmbereich der Resonanzfrequenz in Abhängigkeit von der Spannung $U_D$ der Reihenschwingkreisschaltung nach Figur 1,

Figur 5    Ausführungsbeispiel einer einfachen Tunerschaltung auf der Basis des erfindungsgemäßen Verfahrens,

Figur 6    Ausführungsbeispiel eines einfachen Parallelschwingkreisfilters.

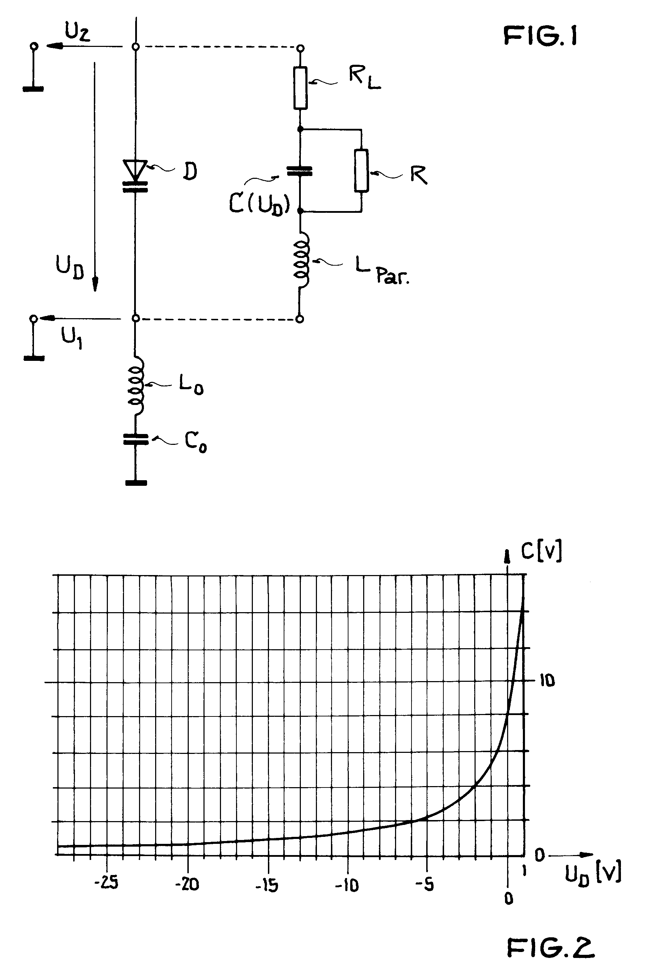

Das Ausführungsbeispiel in Figur 1 ermöglicht eine anschauliche Erläuterung der Wirkungsweise des Verfahrens, dessen Grundlagen bereits oben ausführlich erläutert wurden. Er soll im folgenden nur kurz zusammengefaßt werden.

Die Kapazitätsdiode D, hier als hyperabrupte Kapazitätsdiode ausgeführt, kann gemäß Figur 1 schaltungstheoretisch in folgende Bestandteile zerlegt werden:

- eine spannungsgesteuerte Kapazität $C(U_D)$,

- einen parallel zur Kapazität $C(U_D)$ geschalteten hochohmigen Widerstand R, welcher den Leckstrom veranschaulicht und vernachlässigbar groß ist,

- einen in Reihe zum Widerstand R und der Kapazität $C(U_D)$ liegenden Leitungswiderstand $R_L$ und

- parasitäre Anschlußinduktivitäten $L_{par}$.

Das Ausführungsbeispiel wird gemäß Figur 1 durch eine Spule mit fester Induktivität $L_0$ und einem Kondensator $C_0$ zu einem Reihenschwingkreis ergänzt.

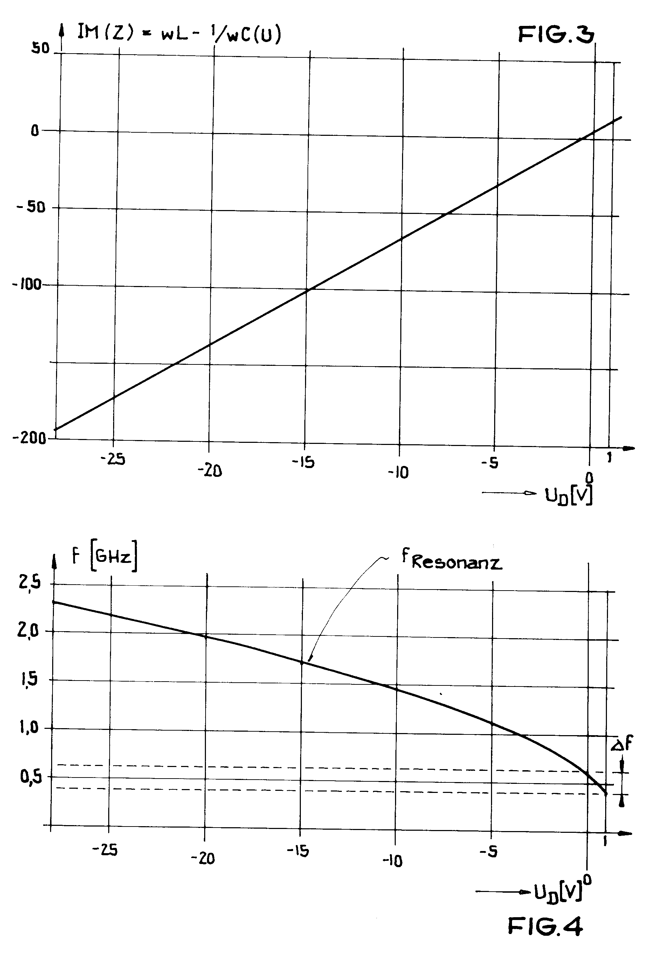

Für diesen Reihenschwingkreis wurde die Gesamtkapazität (Tuning Capacity) in Figur 2 in Abhängigkeit von der Speisespannung $U_D$ der Kapazitätsdiode D - die sich aus der Differenz der Spannungen $U_1$ und $U_2$ ergibt - dargestellt. Dabei ist der durch das erfindungsgemäße Verfahren gewonnene Bereich der Speisespannung, der von 0 Volt bis zur maximal zulässigen Diodendurchlaßspannung (hier 1 V gewählt) geht, eigentlich recht klein. Dies dürfte auch ein Grund dafür sein, daß der Fachmann nicht in der Lage war, den Nutzen einer Ansteuerung der Diode für Verfahren der Resonanzkreisabstimmung zu erkennen. Betrachtet man jedoch den dabei erzielbaren, immensen Kapazitätshub, der im Ausführungsbeispiel von 7 pico Farad (pF) bis ca. 15 pF gegenüber 1-7 pF im Sperrbereich ($U_D < 0$ V) liegt, so wird dies klarer. Unter Berücksichtigung der parasitären Anschlußinduktivitäten ergibt sich dabei für den Imaginärteil des komplexen Widerstands Z , wie in Figur 3 dargestellt, der für hyperabrupte Kapazitätsdioden typische, lineare Verlauf bei einer Resonanzfrequenz von $f_{Res} = 1,50$ GHz. Es ist deutlich zu erkennen, wie der kapazitive Anteil von Z in Sperrichtung mit größer werdender Speisespannung immer mehr verschwindet, bis schließlich der Imaginärteil von Z positiv, also induktiv imaginär wird.

Dieses Phänomen einer spannungsgesteuerten Impedanz mit Vorzeichenwechsel kann für viele Anwendungen in der Elektrotechnik eingesetzt werden. Betrachtet man in Figur 4 basierend darauf den Verlauf der Resonanzfrequenz $f_{res}$ des Reihenschwingkreises aus Figur 1 über die Speisespannung $U_D$, so kann eine Vergrößerung des Durchstimmbereiches um ca. $\Delta f = 200$ MHz, also von 610 MHz bis 410 MHz nachgewiesen werden.

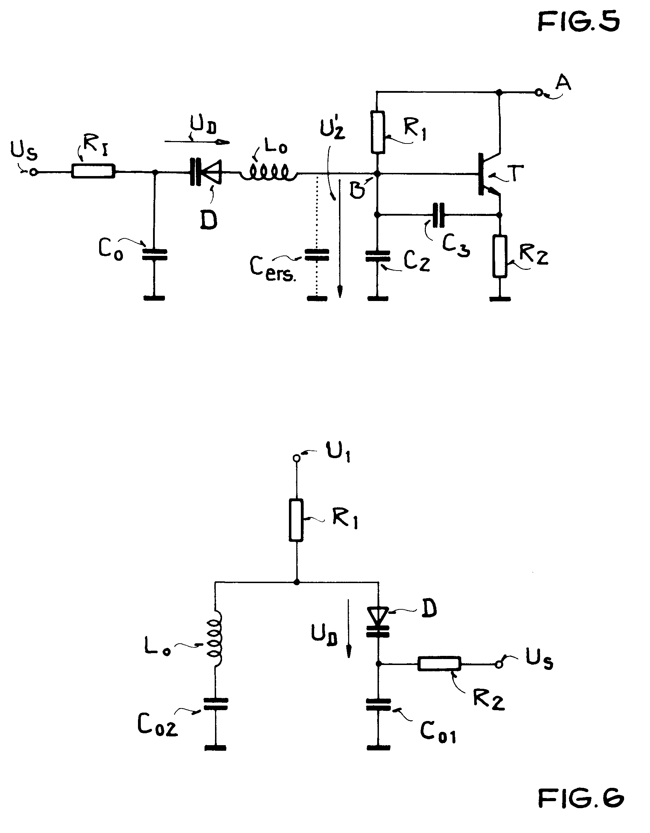

In einem zweiten Ausführungsbeispiel gemäß Figur 5 ist ein einfacher Tunerkreis gezeigt, welcher mittels einer Steuerspannung $U_S$ über einen Vorwiderstand $R_l$ gespeist wird. Der Widerstand $R_l$ verbindet also den Schaltungseingang, an dem die Steuerspannung $U_S$ angeschlossen ist mit einer Kapazitätsdiode D. Der Eingang der Kapazitätsdiode ist dabei mittels einem Vorkondensator $C_0$ auf Masse geschlossen. Die Polung der Kapazitätsdiode D ist entsprechend der Steuerspannung $U_S$ gewählt. In Reihe zur Kapazitätsdiode D befindet sich noch eine Spule mit einer Induktivität $L_0$, welche mit ihrem zweiten Anschluß an den Basiseingang einer Verstärkerstufe geschaltet ist, welche aus einem Netzwerk von Widerständen $R_1$ und $R_2$ sowie von Kondensatoren $C_2$ und $C_3$ um einen Transistor T gebildet wird. Dabei handelt es sich um einen npn-Transistor, dessen Kollektor an eine Betriebsspannungsquelle A angeschlossen und über den Widerstand $R_1$ mit der Basis B verbunden ist. Ferner stellt der weitere Widerstand $R_2$ einen Emitterwiderstand dar, wobei der Emitter über den Kondensator $C_3$ mit der Basis B und mit dem weiteren Kondensator $C_2$ verbunden ist, der seinerseits auf Masse liegt.

Eine Gesamtkapazität $C_{ers}$ am Basiseingang B der Verstärkerstufe wird dabei als Zusammenfassung von den Kondensatoren $C_2$ und $C_3$ sowie den kapazitiven Anteilen des Transistors T gebildet.

Mittels der Verstärkerstufe wird das Basispotential $U_2$ an der Basis B des Transistors T konstant gehalten, so daß über eine Regelung der Steuerspannung $U_S$ die Speisespannung $U_D$ der Kapazitätsdiode D exakt einstellbar ist.

Durch Wahl eines geeigneten Vorwiderstandes $R_l$ entsteht ein Spannungsteiler, der es ermöglicht, eine Ansteuerspannung $U_S$ mit einem deutlich größeren Bereich zu wählen, so daß auch mittels einer einfachen Steuereinheit sehr präzis die gewünschte Spannung an der Diode und damit deren Kapazität eingestellt werden kann.

Die Steuerspannung $U_S$ wird dabei vorzugsweise aus einem Phasenregelkreis gewonnen, da dieser die geforderte Zweipoligkeit der Steuerspannung $U_S$ ohne schaltungstechnische Veränderungen liefern kann.

Der damit eingestellte komplexe Widerstandswert Z der Kapazitätsdiode D bestimmt zusammen mit der Vorkapazität $C_0$ und der Gesamtkapazität $C_{ers}$ am Basiseingang B der Verstärkerstufe sowie der Spuleninduktivität $L_0$ die Resonanzfrequenz des Schwingkrei-

ses.

Basierend auf einer solchen Schaltungsanordnung und dem erfindungsgemäßen Verfahren kann auf einfache Weise eine Tunerschaltung mit einem gesicherten Durchstimmbereich von 920 - 2150 MHz mit entsprechenden, zusätzlichen Sicherheitspuffern, welche Temperaturdrifteffekte ausgleichen, aufgebaut werden, wie er in künftigen SAT-Tunern Einsatz finden wird.

Figur 6 zeigt einen einfachen Parallelschwingkreis, welcher analog zum erfindungsgemäßen Verfahren auch im Durchlaßbereich der Kapazitätsdiode betrieben wird. Auch hier läßt sich mit den in Figur 3 dargestellten, erzielbaren komplexen Widerstandswerten Z eine Erweiterung des Durchstimmbereichs nachweisen.

In Figur 6 besteht der Parallelschwingkreis aus zwei parallelgeschalteten Reihenschaltungen, nämlich einer Kapazitätsdiode D mit einer Resonanzkreiskapazität $C(U_D)$ und einem Kondensator $C_{01}$ bzw. einer Resonanzkreisinduktivität $L_0$ und einem weiteren Kondensator $C_{02}$. Ein Anschluß der Parallelschaltung ist über ein Widerstand $R_1$ auf ein betimmtes Spannungspotential gelegt, während der andere Anschluß auf Masse liegt.

Eine Steuerspannung $U_S$ wird über einen weiteren Widerstand $R_2$ dem Verbindungspunkt der Kapazitätsdiode D mit dem Kondensator $C_{01}$ der Schaltung zugeführt.

Die Resonanzkreisfrequenz $f_{Res}$ ergibt sich aus

$$f_{Res} = 1/(L_0 \cdot C(U_D))^{1/2},$$

wobei $L_0$ der Wert der Resonanzkreisinduktivität und $C(U_D)$ der Wert der Resonanzkreiskapazität der Kapazitätsdiode bei deren Speisespannung $U_D$ darstellen.

Die beiden Kondensatoren $C_{01}$ und $C_{02}$ mit dem Kapazitätswert $C_0$ dienen der Gleichstromentkopplung und erfüllen die Bedingungen

$$C_0 \gg C(U_D) \qquad \text{und} \qquad \frac{1}{\omega C_0} \ll \omega L_0.$$

Für die Steuerspannung $U_S$ gilt

$$U_S = U_1 - U_D - I(R_1 + R_2),$$

wobei $U_D$ die Speisespannung der Kapazitätsdiode D, I der über die Kapazitätsdiode D fließende Strom und $R_1$ bzw. $R_2$ der Widerstandswert der beiden Widerstände $R_1$ und $R_2$ darstellt.

Mit den beiden Widerständen R1 und R2 kann der Steuerspannungsbereich erhöht werden, bei dem die Diode in Flußrichtung gepolt ist. Die Speisespannung $U_D$ und damit der zusätzlich gewonnene Durchstimmbereich bleiben gleich, der jedoch über den eingestellten Strom I in Abhängigkeit der Steuerspannung $U_S$ höher aufgelöst werden kann.

**Patentansprüche**

1. Verfahren zur Resonanzkreisabstimmung eines Schwingkreises, bestehend aus wenigstens einer Spule ($L_o$), einem Kondensator ($C_o$) und einer Kapazitätsdiode (D) mit einem komplexen Widerstand (Z), durch Veränderung einer Speisespannung ($U_D$) über der Kapazitätsdiode (D), dadurch gekennzeichnet, daß die Speisespannung ($U_D$) Werte sowohl im Sperrbereich ($U_D < 0$ V) als auch im Durchlaßbereich ($U_D > 0$ V) der Kapazitätsdiode (D) annimmt.

2. Verfahren gemäß Patentanspruch 1, dadurch gekennzeichnet, daß der Resonanzkreis einen Reihenschwingkreis bildet.

3. Verfahren gemäß Patentanspruch 1, dadurch gekennzeichnet, daß der Resonanzkreis einen Parallelschwingkreis bildet.

4. Verfahren gemäß Patentanspruch 1, dadurch gekennzeichnet, daß der Resonanzkreis in Form einer T-Brücke gebildet wird.

5. Verwendung des Verfahrens gemäß einem der vorhergehenden Patentansprüche in Empfängerkreisen (Tunern) zum Hochfrequenzsignalempfang, insbesondere in SAT-Tunern.

6. Verwendung des Verfahrens gemäß der Patentansprüche 1 bis 4 für durchstimmbare Filterkreise.

FIG.1

FIG.2

IM(Z) = wL - 1/wC(U)   FIG.3

FIG.4

6

FIG.5

FIG.6

**Europäisches Patentamt**

# EUROPÄISCHER RECHERCHENBERICHT

Nummer der Anmeldung

EP 96 11 2500

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | US-A-3 573 631 (CARLSON DAVID J) 6.April 1971 <br> * Spalte 1, Zeile 1 - Spalte 2, Zeile 56; Abbildungen 1,2 * <br> --- | 1-6 | H03J3/18 <br> H03B5/12 |
| X | AT-B-391 965 (PHILIPS NV) 27.Dezember 1990 <br> * Seite 2, Zeile 1 - Seite 4, Zeile 34; Abbildungen 1,3 * <br> --- | 1-6 | |
| X | US-A-3 582 823 (PASOS RUDOLPH F) 1.Juni 1971 <br> * Spalte 1, Zeile 47 - Spalte 5, Zeile 52; Abbildungen 1,3,5A-5F * <br> --- | 1-6 | |
| A | US-A-4 718 117 (MA JOHN Y ET AL) 5.Januar 1988 <br> * Spalte 7, Zeile 30 - Spalte 9, Zeile 24; Abbildungen 8,9 * <br> ----- | 2,4-6 | |

**RECHERCHIERTE SACHGEBIETE (Int.Cl.6)**

H03J
H03B
H03C

Der vorliegende Recherchenbericht wurde für alle Patentansprüche erstellt

| Recherchenort | Abschlußdatum der Recherche | Prüfer |
|---|---|---|
| DEN HAAG | 22.Oktober 1996 | Dhondt, I |

EPO FORM 1503 03.82 (P04C03)

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
............................................................
& : Mitglied der gleichen Patentfamilie, übereinstimmendes Dokument